# EUROPÄISCHE PATENTSCHRIFT

(11) **EP 3 060 031 B1**
(45) Veröffentlichungstag und Bekanntmachung des Hinweises auf die Patenterteilung: **31.05.2017**
(21) Anmeldenummer: 15155824.4
(22) Anmeldetag: 19.02.2015
(51) Int. Cl.: H05K 3/12, H05K 3/28, H05K 1/05

(54) **COIL-COATING-VERFAHREN**
COIL COATING METHOD
PROCÉDÉ D'ENDUCTION DE BANDES EN CONTINU

(43) Veröffentlichungstag der Anmeldung: 24.08.2016
(73) Patentinhaber: voestalpine Stahl GmbH, 4020 Linz (AT)
(72) Erfinder: SCHATZL-LINDER, Michaela, 4611 Buchkirchen (AT); STRAUSS, Bernhard, 4060 Leonding (AT); SELL, Johannes, 4030 Linz (AT); ENSER, Herbert, 4040 Linz (AT); HILBER, Wolfgang, 4293 Gutau (AT); JAKOBY, Bernhard, 4040 Linz (AT)
(74) Vertreter: Jell, Friedrich

(56) Entgegenhaltungen:
- EP-A1- 1 767 849
- WO-A1-2006/076607
- JP-A- 2013 042 098
- US-A1- 2006 158 497

## Beschreibung

Die Erfindung betrifft ein Coil-Coating-Verfahren zur mehrschichtigen Beschichtung eines sich im Banddurchlauf befindlichen endlosen, insbesondere beschichteten, Metallbands, bei dem an einer Flachseite des Metallbands eine Konversionsschicht gegebenenfalls erzeugt wird, nachfolgend auf diese Flachseite mithilfe eines Walzenauftrags eine aushärtbare polymere Grundierung zur Ausbildung einer elektrisch isolierenden Grundierungsschicht und auf diese Grundierungsschicht mithilfe eines Walzenauftrags ein aushärtbarer polymerer Lack zur Ausbildung einer elektrisch isolierenden Lackschicht aufgebracht und gehärtet werden, wobei zwischen Grundierungsschicht und Lackschicht wenigstens eine elektrisch und/oder magnetisch leitende Leiterbahn zumindest bereichsweise aufgedruckt wird.

Eine kontinuierliche Metallbandbeschichtung bzw. Coil-Coating-Verfahren zur mehrschichtigen Beschichtung eines sich im Banddurchlauf befindlichen endlosen Metallbands ist aus dem Stand der Technik bekannt (DE102005061319A1). Bei solchen Verfahren wird an einer Flachseite des Metallbands meist eine Konversionsschicht erzeugt, nachfolgend auf diese Flachseite mithilfe eines Walzenauftrags eine aushärtbare polymere Grundierung zur Ausbildung einer Grundierungsschicht und auf diese Grundierungsschicht mithilfe eines Walzenauftrags ein aushärtbarer polymerer Lack zur Ausbildung einer Lackschicht aufgebracht und ausgehärtet werden. Derartige Verfahren dienen auch zur Funktionalisierung des Metallbands, beispielsweise indem einem Metallband mithilfe des Decklacks eine antistatische, elektromagnetische, anti-bakterielle, elektrische etc. funktionale Eigenschaft gegeben wird.

Zur elektrischen Funktionalisierung eines Metallbands im Coil-Coating-Verfahren ist aus der EP2605280A1 zudem bekannt, endlose elektrische Leiterbahnen zwischen Grundierungsschicht und transparenter Lackschicht aufzudrucken, die die photovoltaischen Zellen elektrisch verbinden. In der Weiterverarbeitung von Metallbändern kommt es aber in den meisten Fällen zu Formänderungen am Metallband, beispielsweise durch Umformen, was zu Leitungsbrüchen an den elektrischen Leiterbahnen führen und damit die elektrischen Funktionalisierung beeinträchtigen kann. Bekannte Coil-Coating-Verfahren können daher reproduzierbar eine standfeste elektrische Funktionalisierung nicht schaffen.EP1767849 A1 offenbart ein Coil-Coating-Verfahren zur mehrschichtigen Beschichtung eines sich im Banddurchlauf befindlichen endlosen, beschichteten, Metallbands wobei mithilfe eines Walzenauftrags eine aushärtbare polymere Grundierung zur Ausbildung einer elektrisch isolierenden Grundierungsschicht und auf diese Grundierungsschicht mithilfe eines Walzenauftrags ein aushärtbarer polymerer Lack zur Ausbildung einer elektrisch isolierenden Lackschicht aufgebracht und gehärtet werden, wobei zwischen Grundierungsschicht und Lackschicht wenigstens eine zumindest elektrisch leitende Leiterbahn zumindest bereichsweise aufgedruckt wird und wobei an der vorgehärteten Grundierungsschicht die Leiterbahn bereichsweise aufgedruckt wird.

Ausgehend vom Eingangs geschilderten Stand der Technik hat sich daher die Erfindung die Aufgabe gestellt, ein Coil-Coating-Verfahren zu schaffen, das reproduzierbar eine standfeste elektrische und/oder magnetische Funktionalisierung eines Metallbands sicherstellen kann. Zudem soll das Coil-Coating-Verfahren einfach anwendbar und kostengünstig in dessen Anwendung sein.

Die Erfindung löst die gestellte Aufgabe dadurch, dass an der vorgehärteten Grundierungsschicht die Leiterbahn bereichsweise aufgedruckt wird und dass Leiterbahn und Lack nass-in-nass aufgebracht werden.

Wird an der vorgehärteten Grundierungsschicht die Leiterbahn bereichsweise aufgedruckt, kann damit auf verfahrenstechnisch einfache Weise für eine ausreichende Haftung der elektrischen und/oder magnetischen Leiterbahn am Metallband gesorgt werden. Dies kann die Reproduzierbarkeit des Verfahrens zur standfesten elektrischen Funktionalisierung eines Metallbands erhöhen. Dazu kann erheblich beitragen, dass Leiterbahn und Lack nass-in-nass aufgebracht werden, weil damit unter anderem innere Spannungen der Beschichtung reduziert werden können. Aufgrund des nass-in-nass Aufbringens kann nämlich eine Übergangszone beispielsweise in der Art einer Mischschicht zwischen Leiterbahn und Lack bzw. Verbindungsgrenzschicht ermöglicht werden, die für homogenere Eigenschaften in diesem Anschlussbereich der Schichten sorgen kann. Diese Übergangszone kann sich bei einer metallischen Leiterbahn in einer besonders haftfesten Interphase zwischen Leiterbahn und Lack ausdrücken. Zudem kann durch das nass-in-nass Aufbringen an der nassen bzw. damit angetrockneten oder vorgehärteten (jedoch nicht endverfestigten) Leiterbahn teilweise ein Verfließen durch den aufgetragenen Lack zugelassen werden, um den Verlauf der Grenzschicht zwischen diesen Schichten zu glätten. Damit können an der Grenzschicht mechanische Spannungen aufgrund thermischer Ausdehnung reduziert werden, die beispielsweise an schaftkantig verlaufenden Leiterbahnen durch Spannungskonzentrationen verstärkt auftreten können. Im Gegensatz zu bekannten Coil-Coating-Verfahren kann daher an der erfindungsgemäßen Beschichtung im endvernetzten Zustand eine erhöhte innere Spannungsfreiheit gewährleistet werden, was zu einer vergleichsweise hohen Reproduzierbarkeit des Verfahrens führen kann.

Im Allgemeinen wird erwähnt, dass das Metallband ein Stahlband, Aluminiumband bzw. deren Legierungen sein kann. Dieses Metallband kann unbeschichtet oder beschichtet (organisch/metallisch), beispielsweise verzinkt oder legierungsverzinkt, sein. Auch kann dieses Metallband ein verzinktes oder legierungsverzinktes Stahlband sein. Im Allgemeinen wird außerdem erwähnt, dass Leiterbahn und Lack derart nass-in-nass aufgebracht werden können, dass damit eine Vermischung der beiden Schichten an deren Grenzschicht zugelassen wird.

Haftfestigkeit und Druckqualität der Leiterbahn können erhöht werden, wenn dass die aufgebrachte Grundierung zumindest bis zum Gelpunkt vorgehärtet wird, weil so -durch Vermeidung einer vollständigen Aushärtung- eine verbesserte Anbindung an angrenzende Schichten ermöglicht werden kann.

Eine mechanisch besonders belastbare Beschichtung kann geschaffen werden, wenn die Grundierungsschicht und/oder Lackschicht durch Trocknung bei einer Substrattemperatur im Bereich von 150 bis 300 Grad Celsius gehärtet werden. Vorzugsweise kann die Grundierungsschicht bei einer Substrattemperatur im Bereich von 180 bis 240 Grad Celsius vorgehärtet werden, um in der Vernetzung den Gelpunkt sicher zu erreichen und damit die Reproduzierbarkeit des Verfahrens zu erhöhen.

Die Reproduzierbarkeit des Verfahrens kann weiter verbessert werden, wenn die Grundierungsschicht und Lackschicht bei einer Substrattemperatur im Bereich von 220 bis 260 Grad Celsius endausgehärtet werden.

Die inneren Spannungen an der Beschichtung können verfahrenstechnisch weiter reduziert werden, wenn die Leiterbahn und Lackschicht gemeinsam verfestigt werden. Bevorzugt erfolgt dies in einem Arbeitsgang gemeinsam, um beispielsweise durch kontinuierliche Prozessparameter die innere Spannungsfreiheit der Beschichtung weiter zu verbessern. Zudem kann dies die Effizienz des Verfahrens deutlich erhöhen, weil in einem Durchlauf das Metallband fertig beschichtet werden kann.

Weisen die Grundierungsschicht und/oder Lackschicht im ausgehärteten Zustand einen Tg-Onset Wert im Bereich von 10 bis 75 Grad Celsius auf, kann die erfindungsgemäße Beschichtung selbst hohen Umformgraden, beispielsweise durch Tiefziehen, des Blechs beschädigungsfrei bzw. ohne Funktionsverlust folgen. Zudem kann durch diesen Tg-Onset Wert der Grundierung und Lackschicht die Leiterbahn mechanisch stabilisiert und damit die Gefahr einer Rissbildung an der elektrischen Leiterbahn reduziert werden. Elektrische Leitungsbrüche können so verbessert vermieden werden, was die Reproduzierbarkeit des Verfahrens weiter erhöhen kann.

Im Allgemeinen wird erwähnt, dass zur Bestimmung des Tg-Onset Werts eine thermomechanische Analyse bei einer Messfrequenz von 0,1 Hz mit einer Heizrate von 5K/min verwendet werden kann.

Für ein zur Verwendung im Innenbereich vorgesehenes Metallband kann bereits ausreichen, wenn der Tg-Onset Wert der Grundierungsschicht einen Bereich von 10 bis 35 Grad Celsius aufweist.

Für ein zur Verwendung im Außenbereich vorgesehenes Metallband kann bereits ausreichen, wenn der Tg-Onset Wert der Grundierungsschicht einen Bereich von 30 bis 75 Grad Celsius aufweist. Zudem kann durch solch einen Tg-Onset Wert mit einer hohen Korrosionsbeständigkeit und einer erhöhten Barrierewirkung gerechnt werden.

Wird die Grundierungsschicht mit einer Schichtdicke zwischen 3 und 30 µm aufgebracht, kann für eine ausreichend hohe elektrische Isolierung bzw. elektrische Durchschlagsfestigkeit gesorgt werden.

Oberflächenunebenheiten und damit eventuell entstehende Spannungsrisse an der Beschichtung können vermindert werden, wenn die elektrische Leiterbahn mit einer Schichtdicke kleiner gleich 15 µm aufgedruckt wird. Zudem kann sich eine Schichtbreite kleiner 5 mm auszeichnen, vorstehende Vorteile zu erreichen bzw. weiter zu unterstützen.

Die Funktionalität des Metallbands kann zusätzlich erweitert werden, wenn zwischen Grundschicht und Lackschicht mindestens ein elektrisches Bauelement aufgedruckt wird, welches elektrische Bauelement mit der Leiterbahn elektrisch verbunden wird. Beispielsweise kann dieses elektrische Bauelement ein Messgrößenaufnehmer darstellen.

Eine Leiterbahn kann beispielsweise verfahrenstechnisch schnell und kostengünstig mithilfe eines Rolle-zu-Rolle-Verfahrens ("Roll-to-Roll") aufgedruckt werden. Dieses Rolle-zu-Rolle-Verfahren kann auch nützlich sein, wenn andere elektrische Bauelemente auf der Grundierungsschicht vorgesehen werden müssen. Beispielsweise kann sich hierzu ein Walzenauftrag auszeichnen, die Effektivität des Coil-Coating-Verfahrens zu erhöhen.

Vorzugsweise wird die Leiterbahn als Rapport aufgedruckt, um die Reproduzierbarkeit des Verfahrens durch ein sich wiederholendes Muster zu erhöhen.

Die mechanische und chemische Beständigkeit der Beschichtung kann erhöht werden, wenn die Grundierung sowie der Lack chemisch vernetzt werden.

In den Figuren ist beispielsweise das erfindungsgemäße Verfahren dargestellt. Es zeigen
- Fig. 1: eine schematische Ansicht auf eine Vorrichtung für ein Coil-Coating-Verfahren,
- Fig. 2: eine teilweise aufgerissene erste Draufsicht auf ein nach Fig. 1 beschichtetes Metallband,
- Fig. 3: eine Schnittansicht nach III-III der Fig. 2,
- Fig. 4: eine vergrößerte Schnittansicht eines Bereichs der Fig. 3,
- Fig. 5: eine teilweise aufgerissene zweite Draufsicht auf das nach Fig. 1 beschichtetes Metallband und
- Fig. 6: eine teilweise aufgerissene dritte Draufsicht auf das nach Fig. 1 beschichtetes Metallband.

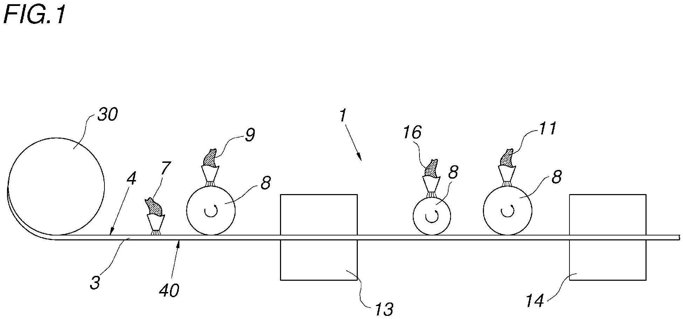

Gemäß Fig. 1 wird eine Vorrichtung 1 zur Durchführung des erfindungsgemäßen Coil-Coating-Verfahrens gezeigt, bei dem ein endloses Metallband 3, nämlich Stahlband, von einem Coil 30 abgewickelt und im Banddurchlauf kontinuierlich mit einer mehrschichtigen Beschichtung 2 versehen wird.

Zunächst wird auf der oberen Flachseite 4 des Metallbands 3 eine Konversionssicht 5 erzeugt - und zwar auf der metallischen Schutzschicht 6 des Metallbands 3. Diese Konversionssicht 5 wird beispielsweise nach Fig. 1 durch ein Aufbringen bzw. Aufsprühen und Quetschen eines Sol-Gels 7 realisiert. Nachfolgend wird auf diese Flachseite 4 mithilfe einer Walze 8 eines nicht näher dargestellten Coaters eine aushärtbare polymere Grundierung 9 bzw. Primer aufgebracht, um eine Grundierungsschicht 10 zu erzeugen. Die Grundierung kann beispielsweise eine Polyesterbasis aufweisen. Damit wird bekanntermaßen die Haftung am und/oder der Korrosionsschutz des Metallbands 3 erhöht.

Nicht näher dargestellt in Fig. 1 ist die Beschichtung der anderen Flachseite 40 des Metallbands 3 im Coil-Coating-Verfahren, welche Flachseite 40 der Flachseite 4 gegenüberliegt. Diese erfolgt ähnlich zur Flachseite 4, in dem zunächst eine Konversionssicht mit einem Sol-Gel und auf diese Konversionssicht ein Decklack aufgebracht wird, was nicht näher dargestellt worden ist. Damit kann die Flachseite 40 vor Flugrost, Weißrost bzw. vor Umwelteinflüssen geschützt werden.

Auf die Grundierungsschicht 10 auf der Flachseite 4 wird dann in weitere Folge ein aushärtbarer polymerer Lack 11, der beispielsweise ebenso eine Polyesterbasis aufweist, zur Ausbildung einer Lackschicht 12 aufgebracht. Dieses Aufbringen erfolgt gleichwie beim Grundierungsauftrag dargestellt, mithilfe einer Walze 8 eines nicht näher dargestellten Coaters. Die aufgetragene Grundierung 9 und der aufgetragene Lack 11 werden jeweils durch einen Trockner 13, 14 gehärtet.

Grundierungsschicht 10 und Lackschicht 12 werden elektrisch isolierend ausgebildet, um das Metallband 3 mit elektrischer Funktionalität versehen zu können. Solche eine elektrische Funktionalität wird geschaffen, indem vor dem Aufbringen des Lacks 11 mithilfe eines Rolle-zu-Rolle Verfahrens mehrere elektrisch leitende Leiterbahnen 15 bereichsweise aufgedruckt werden. Dieses Rolle-zu-Rolle Verfahren erfolgt mithilfe eines Walzenauftrags bei einem Tiefdruckverfahren. Als Paste bzw. Tinte zur Ausbildung der Leiterbahnen 15 wird ein elektrisch leitfähiges Polymer 16, beispielsweise Polystyrolsulfonat, verwendet. Solch eine Paste bzw. Tinte kann stattdessen auch eine metallische Basis, wie beispielsweise Silber, Kupfer oder Gold, eine organische Basis, wie beispielsweise PEDOT ((Poly- 3,4-ethylendioxythiophene) oder eine Graphen Basis aufweisen. Ebenso ist hierfür Carbon oder Graphit denkbar. Tinten und/oder Pasten mit metallischer Basis können sich durch eine besonders günstige Leitfähigkeit auszeichnen, wohingegen Tinten und/oder Pasten mit organischer Basis zumeist eine erhöhte Korrosionsbeständigkeit bieten können.

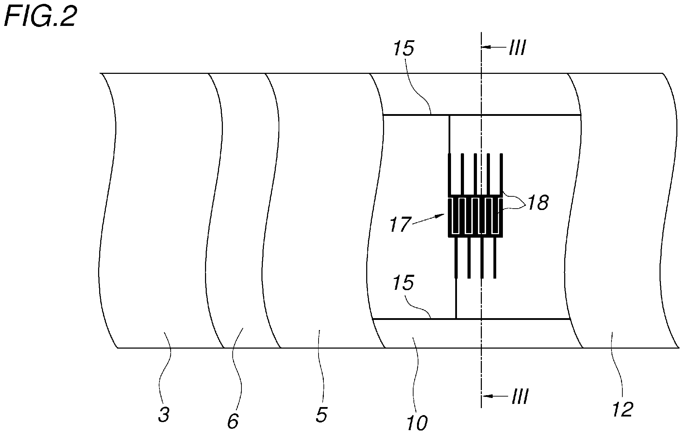

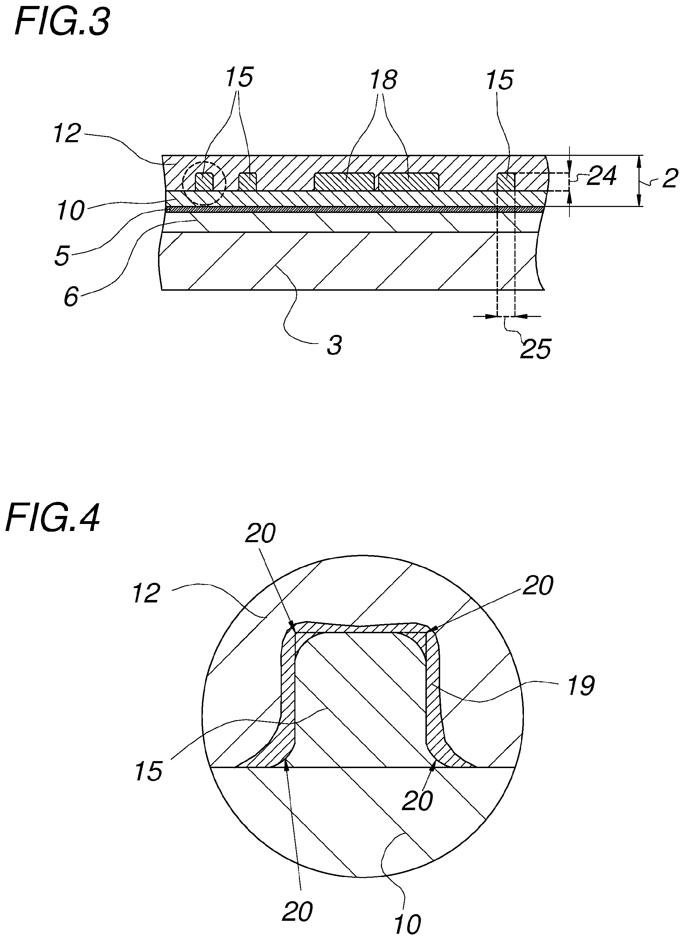

Nachfolgend werden diese aufgedruckten Leiterbahnen 15 von einem Lack 11 abgedeckt. Ein kompakter Schichtverbund bzw. eine kompakte Beschichtung 2 mit zumindest abschnittsweise gekapselten Leiterbahnen 15 ist damit gegeben, wie dies nach den Figuren 2 und 3 zu erkennen ist.
Auch können im Coil-Coating-Verfahren zusätzlich zu solchen Leiterbahnen 15 als elektrische Leitungen auch andere elektrische Bauelemente 17 aufgedruckt werden, wie beispielsweise in den Figuren 2 und 3 dargestellt ein Messgrößenaufnehmer 18, der mit den beiden Leiterbahnen 15 elektrisch verbunden ist.

Im Gegensatz zum Stand der Technik wird jedoch beim erfindungsgemäßen Coil-Coating-Verfahren an der vorgehärteten und damit nicht ausgehärteten Grundierungsschicht 10 die Leiterbahnen 15 aufgedruckt und außerdem werden die beiden Leiterbahnen 15 und der Lack 11 nass-in-nass aufgebracht. Damit wird eine hohe Haftfestigkeit im Schichtverbund der Beschichtung 3 und zudem die Gefahr von Eigenspannungen in der Beschichtung vermindert, wie dies nachfolgend anhand von Fig. 3 näher erläutert wird.

So ist in der nach Fig. 4 vergrößerten Schnittansicht zur Beschichtung 2 eine überzogen dargestellte Übergangszone 19 zu erkennen, die die Leiterbahn 15 ummantelt. Diese Übergangszone 19 kann sich nämlich nicht nur durch Heterohäsion durch gegenseitige Interdiffusion ausbilden, sondern wird besonders durch das nass-in-nass Aufbringen von Tinte bzw. Paste 16 und Lack 11 in der Ausbildung begünstigt. Mit einer homogeneren Eigenschaftsverteilung in der Beschichtung 2 ist zu rechnen, was geringe Eingenspannungen in der Beschichtung 2 garantieren kann. Zudem ist dadurch mit einer erhöhten Haftfestigkeit zwischen diesen beiden angrenzenden Schichten zu rechnen. Außerdem ist in der Fig. 4 ein weiterer Effekt des nass-in-nass Aufbringens zu erkennen. Es tritt nämlich eine Glättung von Kanten 20 der Leiterbahnen 15 ein, was innere Kerbspannungen an der Grenzschicht vermeidet. Die erfindungsgemäße Beschichtung 2 ist daher besonders stabil gegenüber thermischen Spannungen, sodass das erfindunsgemäße Coil-Coating-Verfahren reproduzierbar eine standfeste Beschichtung 2 hergestellt.

Die elektrische Kurzschlußfestigkeit der Beschichtung 2 wird weiter erhöht, indem die aufgebrachte Grundierung 9 zumindest bis zum Gelpunkt vorgehärtet wird, bevor die Leiterbahnen 15 aufgebracht werden. Hierzu wird im Trockner 13 die Grundierungsschicht 10 bei einer Substrattemperatur im Bereich von 180 bis 240 Grad Celsius vorgehärtet. Eine Schichtdicke der Grundierungsschicht zwischen 3 und 30 µm hat sich als ausreichend kurzschlussfest herausgestellt.

Zudem werden Eigenspannungen in der ausgehärteten Beschichtung 2 vermieden, indem die Leiterbahn 15 und der Lack 11 nass-in-nass aufgebracht werden und in einem Arbeitsgang gemeinsam verfestigt werden, wozu der Trockner 14 vorgesehen ist. Auf Basis des Trockners 14 werden zudem die Grundierungsschicht 10 und Lackschicht 12 bei einer Substrattemperatur im Bereich von 220 bis 260 Grad Celsius endausgehärtet. Die damit hergestellte Beschichtung 2 zeigt Grundierungsschicht 10, Lackschicht 12 und Leiterbahn 15 aneinander anschließend. Es ist aber auch vorstellbar, allerdings nicht näher dargestellt, mehrschichtig und eventuell auch elektrisch voneinander isolierte Leiterbahnen 15 zwischen Grundierungsschicht 10 und Lackschicht 12 vorzusehen, um damit mehrere Lagen an Metallisierungsschichten zu bilden. Im Allgemeinen wird erwähnt, dass mit der erfindungsgemäßen Leiterbahn 15 mit einer Schichtdicke 24 kleiner gleich 15 µm der Einfluss auf die Oberfläche der Beschichtung gering ist und je nach Konfiguration der Lackschicht 12 auch optisch nicht erkannt werden kann. Unterstützt werden diese Vorteile, in dem die Leiterbahnen 15 mit einer Schichtbreite 25 kleiner 5 mm aufgedruckt werden und damit die Leiterbahnen 15 schmal gehalten werden. Zudem ist denkbar, die Leiterbahnen 15 bzw. elektrischen Bauelemente 18 optisch zu verdecken, in dem eine opake Lackschicht 12 aufgebracht wird. Es ist aber auch denkbar, dass die Leiterbahnen 15 optisch erkannt werden sollen, um für den Anwender die Bedienbarkeit zu verbessern.

Vorzugsweise weist die ausgehärtete Grundierungsschicht 10 einen Tg-Onset Wert im Bereich von 10 bis 35 Grad Celsius auf, wenn das damit beschichtete Blechband 3 bzw. dessen Teile im Innenbereich Verwendung finden soll. Bei einer Verwendung im Außenbereich bewährt sich ein Tg-Onset Wert der ausgehärteten Grundierungsschicht 10 im Bereich von 30 bis 75 Grad Celsius.

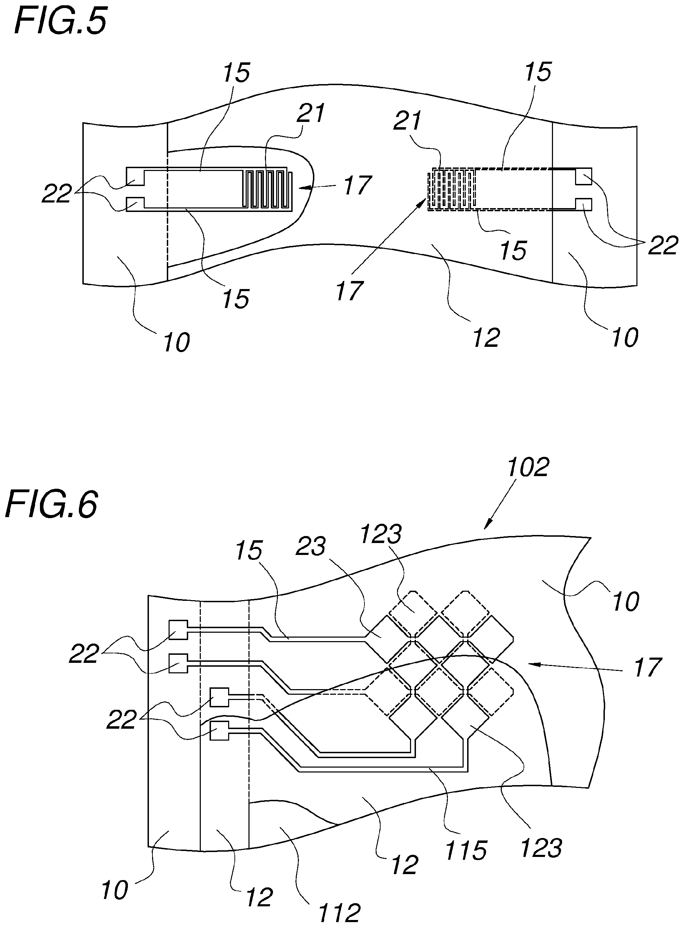

Gemäß den Figuren 5 und 6 werden in aufgerissener Draufsicht weitere Ausführungsbeispiele zur elektrischen Funktionalisierung desselben Blechbands 3 dargestellt.

Im Vergleich zum nach Fig. 2 dargestellten Ausführungsbeispiel zur Funktionalisierung ist bei der Funktionalisierung nach Fig. 5 ein anderes elektrisches Bauelement 17 gezeigt. In der Fig. 5 werden anstatt eines Messgrößenaufnehmers 18 zwei kapazitiver Taster 21 aufgedruckt. Diese kapazitiven Taster 21 sind über Leiterbahnen 15 mit elektrischen Kontaktflächen 22 verbunden, die von der Lackschicht 12 freigestellt sind, um damit einfach zugängliche elektrische Anschlüssen zu schaffen. Der Aufbau der Beschichtung 2 ist gleich zur nach Fig. 3 dargestellten Ausführungsform.

Hingegen ist nach Fig. 6 eine zur Beschichtung 2 anders aufgebaute Beschichtung 102 zu erkennen. Diese Beschichtung 102 unterscheidet sich in einer elektrischen Funktionalisierung in zwei übereinanderliegenden Lagen, die gemeinsam für ein elektrisches Bauelement 17 zusammenwirken. Die erste Lage ist gleich zur Beschichtung 2 aufgebaut und offenbart sich in einer Grundierung 10, elektrischen Leiterbahnen 15 samt Sensorflächen 23 und einer Lackschicht 12. Diese Lackschicht 12 ist wiederum im Bereich von Kontaktflächen 22 freigestellt, wie dies bereits zu Fig. 5 näher erläutert wurde. Nach einem Vorhärten der ersten Lage wird auf diese erneut gedruckt, und zwar in dem wiederum Leiterbahnen 115, Sensorflächen 123 und Lackschicht 112 nass-in-nass aufgetragen und dann verfestigt werden, um damit die zweite Lage der Beschichtung 102 auszubilden. Die Sensorflächen 23 und 123 der beiden Lagen wirken zusammen, ein kapazitives Touchpad als elektrisches Bauelement 17 zu schaffen.

Im Allgemeinen wird erwähnt, dass selbstverständlich auch andere elektrische Bauelemente 17 als die erwähnten elektrischen Leiterbahnen 15, 115 mit dem Lack 12, 112 nass-in-nass aufgetragen werden können.

## Patentansprüche

1. Coil-Coating-Verfahren zur mehrschichtigen Beschichtung eines sich im Banddurchlauf befindlichen endlosen, insbesondere beschichteten, Metallbands (3), bei dem
an einer Flachseite (4) des Metallbands (3) eine Konversionsschicht (5) gegebenenfalls erzeugt wird,
nachfolgend auf diese Flachseite (4) mithilfe eines Walzenauftrags eine aushärtbare polymere Grundierung (9) zur Ausbildung einer elektrisch isolierenden Grundierungsschicht (10) und auf diese Grundierungsschicht (10) mithilfe eines Walzenauftrags ein aushärtbarer polymerer Lack (11) zur Ausbildung einer elektrisch isolierenden Lackschicht (12) aufgebracht und gehärtet werden,
wobei zwischen Grundierungsschicht (10) und Lackschicht (12) wenigstens eine zumindest elektrisch leitende Leiterbahn (15) zumindest bereichsweise aufgedruckt wird,
wobei an der vorgehärteten Grundierungsschicht (10) die Leiterbahn (15) bereichsweise aufgedruckt wird **dadurch gekennzeichnet dass** Leiterbahn (15) und Lack (11) nass-in-nass aufgebracht werden.

2. Coil-Coating-Verfahren nach Anspruch 1, **dadurch gekennzeichnet, dass** die aufgebrachte Grundierung (9) zumindest bis zum Gelpunkt vorgehärtet wird.

3. Coil-Coating-Verfahren nach Anspruch 1 oder 2, **dadurch gekennzeichnet, dass** Grundierungsschicht (10) und/oder Lackschicht (12) durch Trocknung bei einer Substrattemperatur im Bereich von 150 bis 300 Grad Celsius gehärtet werden.

4. Coil-Coating-Verfahren nach Anspruch 2 und 3, **dadurch gekennzeichnet, dass** die Grundierungsschicht (10) bei einer Substrattemperatur im Bereich von 180 bis 240 Grad Celsius vorgehärtet wird.

5. Coil-Coating-Verfahren nach Anspruch 3 oder 4, **dadurch gekennzeichnet, dass** Grundierungsschicht (10) und Lackschicht (12) bei einer Substrattemperatur im Bereich von 220 bis 260 Grad Celsius endausgehärtet werden.

6. Coil-Coating-Verfahren nach einem der Ansprüche 1 bis 5, **dadurch gekennzeichnet, dass** die Leiterbahn (15) und Lackschicht (12) gemeinsam, insbesondere in einem Arbeitsgang, verfestigt werden.

7. Coil-Coating-Verfahren nach einem der Ansprüche 1 bis 6, **dadurch gekennzeichnet, dass** die Grundierungsschicht (10) und/oder Lackschicht (12) im ausgehärteten Zustand einen Tg-Onset Wert im Bereich von 10 bis 75 Grad Celsius aufweisen.

8. Coil-Coating-Verfahren nach Anspruch 7, **dadurch gekennzeichnet, dass** für ein Metallband (3) im Innenbereich der Tg-Onset Wert der Grundierungsschicht (10) einen Bereich von 10 bis 35 Grad Celsius aufweist.

9. Coil-Coating-Verfahren nach Anspruch 7, **dadurch gekennzeichnet, dass** für ein Metallband (3) im Außenbereich der Tg-Onset Wert der Grundierungsschicht (10) einen Bereich von 30 bis 75 Grad Celsius aufweist.

10. Coil-Coating-Verfahren nach einem der Ansprüche 1 bis 9, **dadurch gekennzeichnet, dass** eine Grundierungsschicht (10) mit einer Schichtdicke zwischen 3 und 30 µm aufgebracht wird.

11. Coil-Coating-Verfahren nach einem der Ansprüche 1 bis 10, **dadurch gekennzeichnet, dass** die elektrische Leiterbahn (15) mit einer Schichtdicke (24) kleiner gleich 15 µm und/oder mit einer Schichtbreite (25) kleiner 5 mm aufgedruckt wird.

12. Coil-Coating-Verfahren nach einem der Ansprüche 1 bis 11, **dadurch gekennzeichnet, dass** zwischen Grundschicht (10) und Lackschicht (12) mindestens ein elektrisches Bauelement (17), insbesondere ein Messgrößenaufnehmer (18), aufgedruckt wird, welches elektrische Bauelement (17) mit der Leiterbahn (15) elektrisch verbunden wird.

13. Coil-Coating-Verfahren nach einem der Ansprüche 1 bis 12, **dadurch gekennzeichnet, dass** die elektrische Leiterbahn (15) mithilfe eines Rolle-zu-Rolle-Verfahrens, insbesondere Walzenauftrags, aufgedruckt wird.

14. Coil-Coating-Verfahren nach einem der Ansprüche 1 bis 13, **dadurch gekennzeichnet, dass** die Leiterbahn (15) als Rapport aufgedruckt wird.

15. Coil-Coating-Verfahren nach einem der Ansprüche 1 bis 14, **dadurch gekennzeichnet, dass** die Grundierung (9) sowie der Lack (11) chemisch vernetzt werden.

## Claims

1. A coil coating method for multilayer coating of a continuous, more particularly coated, metal strip (3) which is disposed in the strip passage, wherein
on a flat side (4) of the metal strip (3) a conversion layer (5) is optionally produced,
subsequently a curable polymer primer (9) is applied on said flat side (4) by means of a roller application for forming an electrically insulating primer layer (10), and a curable polymer varnish (11) is applied and cured on said primer layer (10) by means of roller application for forming an electrically insulating varnish layer (12),
wherein at least one at least electrically conductive conductor track (15) is printed at least in some areas between the primer layer (10) and the varnish layer (12), wherein the conductor track (15) is printed in some areas on the pre-cured primer layer (10), **characterized in that** the conductor track (15) and the varnish (11) are applied by a wet-on-wet process.

2. A coil coating method according to claim 1, **characterized in that** the applied primer (9) is pre-cured at least up to the gel point.

3. A coil coating method according to claim 1 or 2, **characterized in that** the primer layer (10) and/or the varnish layer (12) are cured by drying at a substrate temperature in the range of 150 to 300°C.

4. A coil coating method according to claim 2 and 3, **characterized in that** the primer layer (10) is pre-cured at a substrate temperature in the range of 180 to 240°C.

5. A coil coating method according to claim 3 or 4, **characterized in that** the primer layer (10) and varnish layer (12) are finally cured at a substrate temperature in the range of 220 to 260°C.

6. A coil coating method according to one of the claims 1 to 5, **characterized in that** the conductor track (15) and varnish layer (12) are solidified jointly, more particularly in one working cycle.

7. A coil coating method according to one of the claims 1 to 6, **characterized in that** the primer layer (10) and/or varnish layer (12) have a Tg-onset value in the range of 10 to 75°C in the cured state.

8. A coil coating method according to claim 7, **characterized in that** the Tg-onset value of the primer layer (10) for a metal strip (3) in the inner region has a range of 10 to 35°C.

9. A coil coating method according to claim 7, **characterized in that** the Tg-onset value of the primer layer (10) for a metal strip (3) in the outer region has a range of 30 to 75°C.

10. A coil coating method according to one of the claims 1 to 9, **characterized in that** a primer layer (10) is applied with a layer thickness of between 3 and 30 µm.

11. A coil coating method according to one of the claims 1 to 10, **characterized in that** the electrical conductor track (15) is printed with a layer thickness (24) of less than or equal to 15 µm and/or with a layer width (25) of less than 5 mm.

12. A coil coating method according to one of the claims 1 to 11, **characterized in that** at least one electrical component (17), more particularly a measurement transducer (18), is printed between the primer layer (10) and varnish layer (12), which electrical component (17) is electrically connected to the conductor track (15).

13. A coil coating method according to one of the claims 1 to 12, **characterized in that** the electrical conductor track (15) is printed by means of a reel-to-reel process, more particularly roller application.

14. A coil coating method according to one of the claims 1 to 13, **characterized in that** the conductor track (15) is printed as a repeat.

15. A coil coating method according to one of the claims 1 to 14, **characterized in that** the primer (9) and the varnish (11) are chemically cross-linked.

## Revendications

1. Procédé de couchage sur bande pour le revêtement en plusieurs couches d'une bande métallique (3) sans fin, en particulier revêtue, qui se trouve dans le passage de bande, dans lequel
une couche de conversion (5) est créée si nécessaire sur une face plate (4) de la bande métallique (3),
un apprêt polymère durcissable (9) est ensuite appliqué sur cette face plate (4) à l'aide d'un cylindre pour former une couche d'apprêt (10) isolante électrique et un vernis polymère durcissable (11) est appliqué à l'aide d'un cylindre et durci sur cette couche d'apprêt (10) pour former une couche de vernis (12) isolante électrique,
au moins une piste (15) conductrice au moins électriquement étant imprimée au moins par zones entre la couche d'apprêt (10) et la couche de vernis (12),
la piste conductrice (15) étant imprimée au moins par zones sur la couche d'apprêt (10) durcie,
**caractérisé en ce que** la piste conductrice (15) et le vernis (11) sont appliqués mouillé sur mouillé.

2. Procédé de couchage sur bande selon la revendication 1, **caractérisé en ce que** l'apprêt (9) appliqué est pré-durci au moins jusqu'au point de gélification.

3. Procédé de couchage sur bande selon la revendication 1 ou 2, **caractérisé en ce que** la couche d'apprêt (10) et/ou la couche de vernis (12) sont durcies par séchage à une température du substrat comprise entre 150 et 300 degrés Celsius.

4. Procédé de couchage sur bande selon les revendications 2 et 3, **caractérisé en ce que** la couche d'apprêt (10) est pré-durcie à une température de substrat comprise entre 180 et 240 degrés Celsius.

5. Procédé de couchage sur bande selon la revendication 3 ou 4, **caractérisé en ce que** la couche d'apprêt (10) et la couche de vernis (12) sont amenées à leur dureté finale à une température de substrat de 220 à 260 degrés Celsius.

6. Procédé de couchage sur bande selon l'une des revendications 1 à 5, **caractérisé en ce que** la piste conductrice (15) et la couche de vernis (12) sont solidifiées ensemble, en particulier au cours de la même étape du travail.

7. Procédé de couchage sur bande selon l'une des revendications 1 à 6, **caractérisé en ce que** la couche d'apprêt (10) et/ou la couche de vernis (12) dans l'état durci présentent une valeur de début de Tg comprise entre 10 et 75 degrés Celsius.

8. Procédé de couchage sur bande selon la revendication 7, **caractérisé en ce que** pour une bande métallique (3) pour l'intérieur, la valeur de début de Tg de la couche d'apprêt (10) est comprise entre 10 et 35 degrés Celsius.

9. Procédé de couchage sur bande selon la revendication 7, **caractérisé en ce que** pour une bande métallique (3) pour l'extérieur, la valeur de début de Tg de la couche d'apprêt (10) et comprise entre 30 et 75 degrés Celsius.

10. Procédé de couchage sur bande selon l'une des revendications 1 à 9, **caractérisé en ce qu'**une couche d'apprêt (10) d'une épaisseur comprise entre 3 et 30 µm est appliquée.

11. Procédé de couchage sur bande selon l'une des revendications 1 à 10, **caractérisé en ce que** la piste (15) conductrice électrique est imprimée sur une épaisseur de couche (24) inférieure ou égale à 15 µm et/ou sur une largeur de couche (25) inférieure à 5 mm.

12. Procédé de couchage sur bande selon l'une des revendications 1 à 11, **caractérisé en ce qu'**au moins un composant électrique (17), en particulier un capteur de grandeur de mesure (18), est imprimé entre la couche de base (10) et la couche de vernis (12), lequel composant électrique (17) est relié électriquement à la piste conductrice (15).

13. Procédé de couchage sur bande selon l'une des revendications 1 à 12, **caractérisé en ce que** la piste (15) conductrice électrique est imprimée à l'aide d'un procédé de rouleau à rouleau, en particulier appliquée avec un cylindre.

14. Procédé de couchage sur bande selon l'une des revendications 1 à 13, **caractérisé en ce que** la piste conductrice (15) est imprimée sous la forme d'un rapport de dessin.

15. Procédé de couchage sur bande selon l'une des revendications 1 à 14, **caractérisé en ce que** l'apprêt (9) et le vernis (11) sont polymérisés chimiquement.
